(19) Europäisches Patentamt
European Patent Office
Office européen des brevets

(11) **EP 3 144 411 B1**

(12) **EUROPEAN PATENT SPECIFICATION**

(45) Date of publication and mention
of the grant of the patent:
**11.03.2020 Bulletin 2020/11**

(51) Int Cl.:
***C23C 14/54*** *(2006.01)*     ***C23C 14/24*** *(2006.01)*
***G01B 7/06*** *(2006.01)*

(21) Application number: **14891722.2**

(22) Date of filing: **01.09.2014**

(86) International application number:
**PCT/CN2014/085658**

(87) International publication number:
**WO 2015/172463 (19.11.2015 Gazette 2015/46)**

(54) **MEASUREMENT APPARATUS AND COATING DEVICE**

MESSVORRICHTUNG UND BESCHICHTUNGSVORRICHTUNG

APPAREIL DE MESURE ET DISPOSITIF DE REVÊTEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.05.2014 CN 201410200994**

(43) Date of publication of application:
**22.03.2017 Bulletin 2017/12**

(73) Proprietors:
• **BOE Technology Group Co., Ltd.
Beijing 100015 (CN)**
• **Ordos Yuansheng Optoelectronics Co., Ltd.
Ordos, Inner Mongolia 017020 (CN)**

(72) Inventors:
• **WU, Haidong
Beijing 100176 (CN)**
• **MA, Qun
Beijing 100176 (CN)**

(74) Representative: **Isarpatent
Patent- und Rechtsanwälte Behnisch Barth
Charles
Hassa Peckmann & Partner mbB
Friedrichstrasse 31
80801 München (DE)**

(56) References cited:
**CN-A- 102 465 262**     **CN-A- 103 469 172**
**JP-A- H02 174 411**     **JP-A- 2008 122 200**
**US-A1- 2002 152 803**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## TECHNICAL FIELD

The present disclosure relates to the field of measurement technology, and in particular to a measurement apparatus and a film-coating device.

## BACKGROUND

At present, microelectronic film, optical film, antioxidant film, giant magnetoresistance film and high temperature superconductor film have been widely applied in industry and the daily life. With respect to the films for a large scale integrated circuit, a liquid crystal panel and a liquid crystal display (LED) component, any small change in film thickness may adversely affect the performance of the component due to the increasingly improved integration degree. In addition, the properties of the film, such as light-transmission performance, conductivity and insulativity, are closely associated with its thickness.

Hence, as a very important parameter, the film thickness is directly related to the normal operation of the film, and during the production, it is necessary to acquire the film thickness.

Along with the progress of science and technology and the application of precise instrument, there are many methods for measuring the film thickness. Usually, a crystal oscillator sheet is used to measure the film thickness in real time. US 2002/0152803 A1 discloses systems and methods of monitoring thin film deposition.

However, the inventor finds that, when the crystal oscillator sheet is adopted, the measurement accuracy is insufficient due to environmental factors.

## SUMMARY

An object of the present disclosure is to provide a measurement apparatus and a film-coating device, so as to improve the accuracy when a film thickness is measured using a crystal oscillator sheet.

In one aspect, the present disclosure provides a measurement apparatus for measuring a thickness of a film formed on a to-be-coated module, as disclosed in appended claim 1.

In another aspect, the present disclosure provides a film-coating device, including a film-coating machine configured to coat a to-be-coated module with a film, and a measurement apparatus according to the present invention.

Alternatively, the frequency-variation target value is equal to a difference between the frequency-variation initial value and the frequency-variation modified value.

Alternatively, the film-coating device further includes a controller configured to control a thickness of the film coated by the film-coating machine in accordance with an actual value of the thickness of the film.

According to the embodiments of the present disclosure, the first quartz-crystal oscillator sheet is provided so as to obtain an initial value of the film using an existing film thickness measuring method. As described hereinabove, the frequency variation of the quartz-crystal oscillator sheet is related to both the film thickness and the environmental factors, so the film thickness calculated based on the oscillation frequency variation of the quartz-crystal oscillator sheet coated with the film is inaccurate. In this case, the second quartz-crystal oscillator sheet is further provided and shielded during the film-coating so as not to be coated with the film. The modified value may be obtained based on the oscillation frequency variation of the second quartz-crystal oscillator sheet, so as to remove an error in the oscillation frequency variation of the due to the environmental factors from the initial value of the film thickness, thereby to improve the film thickness detection accuracy.

## BRIEF DESCRIPTION OF THE DRAWINGS

Fig.1 is a schematic view showing the situation where a plurality of quartz-crystal oscillator sheets cooperates with a shielding mechanism; and
Fig.2 is a schematic view showing a film-coating device for a vacuum evaporation according to one embodiment of the present disclosure.

## DETAILED DESCRIPTION

According to the measurement apparatus and the film-coating device in the embodiments of the present disclosure, a quartz-crystal oscillator sheet not coated with a film is used to measure the influence on the frequency variation due to the environmental factors during the film-coating, so as to improve the measurement accuracy.

In order to facilitate the understanding of the present disclosure, the background knowledge involved therein will be described hereinafter.

When a film thickness is measured by a quartz-crystal oscillator sheet, a following approximate linearity relationship between an oscillation frequency variation of the quartz-crystal oscillator sheet and a thickness of a deposited film is used:

$$\Delta f = -\frac{f_Q^2 \rho_f}{N \rho_Q} \Delta d_f \; .$$

where $\Delta f$ is the oscillation frequency variation of the quartz-crystal oscillator sheet, $\Delta d_f$ is the thickness of the

deposited film, $\rho_f$ is a density of the deposited film, $\rho_Q$ is a density of the quartz-crystal oscillator sheet, $f_Q$ is an inherent resonant frequency of the quartz-crystal oscillator sheet, and $N$ is a frequency constant of the quartz-crystal oscillator sheet.

As can be seen from the above equation, when there is a small change in the thickness of the deposited film, it may be deemed that there exists approximate linearity relationship between $\Delta f$ and $\Delta d_f$, so it is able to obtain the film thickness based on the oscillation frequency variation of the quartz-crystal oscillator sheet.

However, the oscillation frequency variation of the quartz-crystal oscillator sheet is related to both the thickness of the deposited film and an environmental factor within a film-coating cavity (e.g., temperature, vacuum degree). Hence, it is impossible to obtain the accurate film thickness using the crystal oscillator sheet.

The present disclosure provides in some embodiments a measurement apparatus for measuring a thickness of a film formed on a to-be-coated module, which includes first quartz-crystal oscillator sheet coated with the film during the film-coating, a second quartz-crystal oscillator sheet identical to the first quartz-crystal oscillator sheet and shielded during the film-coating so as not to be coated with the film, an excitation source generation unit configured to generate alternating current and output the alternating current to the first quartz-crystal oscillator sheet and the second quartz-crystal oscillator sheet, a first calculation module configured to calculate a frequency-variation initial value in accordance with a first response signal generated in response to the alternating current by the first quartz-crystal oscillator sheet during the film-coating, a second calculation module configured to calculate a frequency-variation modified value in accordance with a second response signal generated in response to the alternating current by the second quartz-crystal oscillator sheet during the film-coating, and a third calculation module configured to calculate a thickness of the film in accordance with a frequency-variation target value obtained by modifying the frequency-variation initial value with the frequency-variation modified value.

According to the embodiments of the present disclosure, the first quartz-crystal oscillator sheet is provided so as to obtain an initial value of the film using an existing film thickness measuring method. As described hereinabove, the frequency variation of the quartz-crystal oscillator sheet is related to both the film thickness and the environmental factors, so the film thickness calculated based on the oscillation frequency variation of the quartz-crystal oscillator sheet coated with the film is inaccurate. In this case, the second quartz-crystal oscillator sheet is further provided and shielded during the film-coating so as not to be coated with the film. The modified value may be obtained based on the oscillation frequency variation of the second quartz-crystal oscillator sheet, so as to remove an error in the oscillation frequency variation of the due to the environmental factors from the initial value of the film thickness, and obtain the frequency variation target value in an accurate manner, thereby to accurately calculate the film thickness in accordance with the frequency variation target value capable of accurately reflecting the change in the film thickness.

Alternatively, the frequency-variation target value is equal to a difference between the frequency-variation initial value and the frequency-variation modified value.

During the implementation, it is necessary to shield the second quartz-crystal oscillator sheet during the film-coating so as not to be coated with the film. Hence, a shielding mechanism may be provided in the measurement apparatus to shield the second quartz-crystal oscillator sheet during the film-coating, so as to prevent the second quartz-crystal oscillator sheet from being coated with the film.

Of course, the shielding mechanism may also be arranged on a film-coating machine, which will be described hereinafter.

In order to improve the measurement accuracy, there are a plurality of second quartz-crystal oscillator sheet. The second calculation module is configured to calculate a frequency-variation median value of each second quartz-crystal oscillator sheet in accordance with the second response signal generated in response to the alternating current by each second quartz-crystal oscillator sheet during the film-coating, and calculate a mean value of all the frequency-variation median values as the frequency-variation modified value.

The present disclosure further provides in some embodiments a film-coating device, which includes a film-coating machine configured to coat a to-be-coated module with a film, and a measurement apparatus. The measurement apparatus includes a first quartz-crystal oscillator sheet coated with the film during the film-coating, a second quartz-crystal oscillator sheet identical to the first quartz-crystal oscillator sheet and shielded during film-coating so as not to be coated with the film, an excitation source generation unit configured to generate alternating current and output the alternating current to the first quartz-crystal oscillator sheet and the second quartz-crystal oscillator sheet, a first calculation module configured to calculate a frequency-variation initial value in accordance with a first response signal generated in response to the alternating current by the first quartz-crystal oscillator sheet during the film-coating, a second calculation module configured to calculate a frequency-variation modified value in accordance with a second response signal generated in response to the alternating current by the second quartz-crystal oscillator sheet during the film-coating, and a third calculation module configured to calculate a thickness of the film in accordance with a frequency-variation target value obtained by modifying the frequency-variation initial value with the frequency-variation modified value.

Alternatively, the frequency-variation target value is equal to a difference between the frequency-variation initial value and the frequency-variation modified value.

The film-coating device further includes a shielding module configured to shield the second quartz-crystal oscillator sheet during the film-coating, so as to prevent the second quartz-crystal oscillator sheet from being coated with the film.

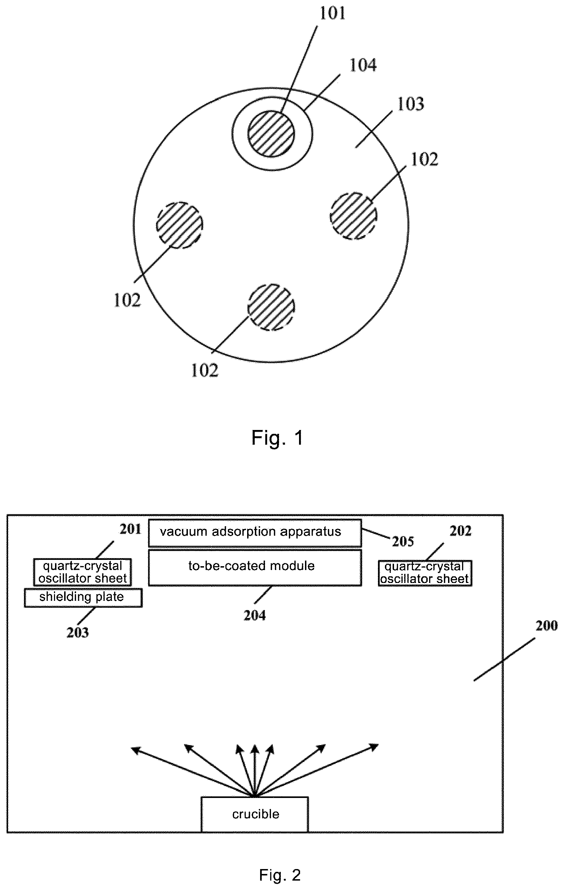

For the film-coating device, in order to improve the measurement accuracy and reduce the replacement times of the crystal oscillator sheet for measurement, as shown in Fig.1, the first quartz-crystal oscillator sheet 101 and the second quartz-crystal oscillator sheet 102 are arranged in a circular manner, the shielding module is a rotatable shielding sheet 103 with a via-hole 104, and the rotatable shielding sheet 103 is rotated in such a manner as to enable the via-hole 104 to be above different quartz-crystal oscillator sheets.

It should be appreciated that, the so-called first quartz-crystal oscillator sheet and the second quartz-crystal oscillator sheet refer to the sheets with respect to a certain film-coating operation. As shown in Fig.1, the first quartz-crystal oscillator sheet is located at the top, and the other quartz-crystal oscillator sheets are the second quartz-crystal oscillator sheets.

When the via-hole is rotated by 90 degrees counterclockwise and the next film-coating operation is performed, the first quartz-crystal oscillator sheet is the one on the left, and the other quartz-crystal oscillator sheets are the second quartz-crystal oscillator sheets.

For the structure in Fig.1, the quartz-crystal oscillator sheets may be replaced after at least three film-coating operations. In the first two measurement operations, there may be two or more quartz-crystal oscillator sheets for measuring the oscillation frequency variation due to the environmental factors, so it is able to improve the measurement accuracy.

During the film-coating, it is able to measure the film thickness and control the operation of the film-coating machine based on the film thickness. At this time, the film-coating device further includes a controller configured to control a thickness of the film coated by the film-coating machine in accordance with an actual value of the thickness of the film.

For example, for the vacuum evaporation process, an evaporation temperature and a material feeding speed may be controlled.

In the embodiments of the present disclosure, the quartz-crystal oscillator sheets may be arranged at any position within the film-coating cavity. However, when the quartz-crystal oscillator sheets and the to-be-coated module are arranged at different levels, the films formed on the quartz-crystal oscillator sheets and the to-be-coated module may be of different thicknesses. At this time, a modification factor needs to be provided so as to modify the film thickness.

In order to avoid a complex process and a resultant inaccurate film thickness due to an inaccurate modification factor, the film-coating machine includes a vacuum adsorption apparatus 205 including an adsorption surface and configured to adsorb the to-be-coated module. The quartz-crystal oscillator sheets and the to-be-coated module are arranged at the same level, i.e., the first quartz-crystal oscillator sheet and the second quartz-crystal oscillator sheet are arranged at a level identical to the to-be-coated module.

As there exists a plurality of second quartz-crystal oscillator sheets, the second calculation module is configured to calculate a frequency-variation median value of each second quartz-crystal oscillator sheet in accordance with the second response signal generated in response to the alternating electric current by each second quartz-crystal oscillator sheet during the film-coating, and calculate a mean value of all the frequency-variation median values as the frequency-variation modified value.

The present disclosure will be described in details in conjunction with a more specific example.

Fig.2 is a schematic view showing the film-coating device for vacuum evaporation according to one embodiment of the present disclosure.

Before the coating, initial oscillation frequencies $f_1$ and $f_2$ of the quartz-crystal oscillator sheet 201 and the quartz-crystal oscillator sheet 202 are measured at first. The quartz-crystal oscillator sheet 201 is shielded by a shielding plate so as not to be coated with the film during the film-coating, while the quartz-crystal oscillator sheet 202 is exposed and a film may be formed on surfaces of the quartz-crystal oscillator sheet 202 and the to-be-coated module 204 through an evaporation gas generated by a crucible.

In order not to set the modification factor, the quartz-crystal oscillator sheet 202 and the to-be-coated module 204 are arranged at the same level.

After the coating, the oscillation frequencies $f_1'$ and $f_2'$ of the two quartz-crystal oscillator sheets may be measured, so as to obtain the equation $\Delta f =(f_2'-f2)-(f_1'-f1)$. $\Delta f'= f_1'-f1$, and it represents the oscillation frequency variation of the crystal oscillator sheet due to any change in the environmental factor. The accurate film thickness may be obtained through the following formula:

$$\Delta f = -\frac{f_Q^2 \rho_f}{N \rho_Q} \Delta d_f$$

.

**Claims**

1. A measurement apparatus for measuring a thickness of a film formed on a to-be-coated module, comprising:

   a first quartz-crystal oscillator sheet coated with the film during the film-coating;

a second quartz-crystal oscillator sheet identical to the first quartz-crystal oscillator sheet and shielded during the film-coating so as not to be coated with the film;

an excitation source generation unit configured to generate alternating current and output the alternating current to the first quartz-crystal oscillator sheet and the second quartz-crystal oscillator sheet;

a first calculation module configured to calculate a frequency-variation initial value in accordance with a first response signal generated in response to the alternating current by the first quartz-crystal oscillator sheet during the film-coating;

a second calculation module configured to calculate a frequency-variation modified value in accordance with a second response signal generated in response to the alternating current by the second quartz-crystal oscillator sheet during the film-coating;

a third calculation module configured to calculate a thickness of the film in accordance with a frequency-variation target value obtained by modifying the frequency-variation initial value with the frequency-variation modified value; and

a shielding module configured to shield the second quartz-crystal oscillator sheet during the film-coating, so as to prevent the second quartz-crystal oscillator sheet from being coated with the film;

**characterized in that** the measurement apparatus further comprises a vacuum adsorption apparatus comprising an adsorption surface and configured to adsorb the to-be-coated module, wherein the first quartz-crystal oscillator sheet and the second quartz-crystal oscillator sheet are arranged at a level identical to the to-be-coated module;

the first quartz-crystal oscillator sheet and the second quartz-crystal oscillator sheet are arranged in a circular manner, the shielding module is a rotatable shielding sheet with a via-hole, and the rotatable shielding sheet is rotated in such a manner as to enable the via-hole to be above different quartz-crystal oscillator sheets;

there exists a plurality of second quartz-crystal oscillator sheets, and the second calculation module is configured to calculate a frequency-variation median value of each second quartz-crystal oscillator sheet in accordance with the second response signal generated in response to the alternating current by each second quartz-crystal oscillator sheet during the film-coating, and calculate a mean value of all the frequency-variation median values as the frequency-variation modified value.

2. The measurement apparatus according to claim 1, wherein the frequency-variation target value is equal to a difference between the frequency-variation initial value and the frequency-variation modified value.

3. A film-coating device, comprising a film-coating machine configured to coat a to-be-coated module with a film, and a measurement apparatus, wherein the measurement apparatus comprises:

a first quartz-crystal oscillator sheet coated with the film during the film-coating;

a second quartz-crystal oscillator sheet identical to the first quartz-crystal oscillator sheet and shielded during film-coating so as not to be coated with the film;

an excitation source generation unit configured to generate alternating current and output the alternating current to the first quartz-crystal oscillator sheet and the second quartz-crystal oscillator sheet;

a first calculation module configured to calculate a frequency-variation initial value in accordance with a first response signal generated in response to the alternating current by the first quartz-crystal oscillator sheet during the film-coating;

a second calculation module configured to calculate a frequency-variation modified value in accordance with a second response signal generated in response to the alternating current by the second quartz-crystal oscillator sheet during the film-coating;

a third calculation module configured to calculate a thickness of the film in accordance with a frequency-variation target value obtained by modifying the frequency-variation initial value with the frequency-variation modified value; and

a shielding module configured to shield the second quartz-crystal oscillator sheet during the film-coating, so as to prevent the second quartz-crystal oscillator sheet from being coated with the film;

**characterized in that** the measurement apparatus further comprises a vacuum adsorption apparatus comprising an adsorption surface and configured to adsorb the to-be-coated module, wherein the first quartz-crystal oscillator sheet and the second quartz-crystal oscillator sheet are arranged at a level identical to the to-be-coated module;

the first quartz-crystal oscillator sheet and the second quartz-crystal oscillator sheet are arranged in a circular manner, the shielding module is a rotatable shielding sheet with a via-hole, and the rotatable shielding sheet is rotated in such a manner as to enable the via-hole to be above different quartz-crystal oscillator sheets;

there exists a plurality of second quartz-crystal oscillator sheets, and the second calculation module is configured to calculate a frequency-variation median value of each second quartz-crystal oscillator sheet in accordance with the second response signal generated in response to the alternating current by each second quartz-crystal oscillator sheet during the film-coating, and calculate a mean value of all the frequency-variation median values as the frequency-variation modified value.

4. The film-coating device according to claim 3, wherein the frequency-variation target value is equal to a difference between the frequency-variation initial value and the frequency-variation modified value.

5. The film-coating device according to claim 3, further comprising:
a controller configured to control a thickness of the film coated by the film-coating machine in accordance with an actual value of the thickness of the film.

**Patentansprüche**

1. Messvorrichtung zum Messen einer Dicke eines auf einem zu beschichtenden Modul gebildeten Films, umfassend:

eine erste Quarzkristalloszillatorbahn, die während der Filmbeschichtung mit dem Film beschichtet wird;
eine zweite Quarzkristalloszillatorbahn, die mit der ersten Quarzkristalloszillatorbahn identisch ist und während der Filmbeschichtung so abgeschirmt wird, dass sie nicht mit dem Film beschichtet wird;
eine Erregungsquellengenerierungseinheit, die dafür eingerichtet ist, Wechselstrom zu generieren und den Wechselstrom an die erste Quarzkristalloszillatorbahn und die zweite Quarzkristalloszillatorbahn auszugeben;
ein erstes Berechnungsmodul, das dafür eingerichtet ist, einen Frequenzvariations-Anfangswert gemäß einem ersten Antwortsignal zu berechnen, das in Reaktion auf den Wechselstrom durch die erste Quarzkristalloszillatorbahn während der Filmbeschichtung generiert wird;
ein zweites Berechnungsmodul, das dafür eingerichtet ist, einen Frequenzvariations-Modifizierungswert gemäß einem zweites Antwortsignal zu berechnen, das in Reaktion auf den Wechselstrom durch die zweite Quarzkristalloszillatorbahn während der Filmbeschichtung generiert wird;
ein drittes Berechnungsmodul, das dafür eingerichtet ist, eine Dicke des Films gemäß einem Frequenzvariations-Zielwert zu berechnen, der durch Modifizieren des Frequenzvariations-Anfangswertes mit dem Frequenzvariations-Modifizierungswert erhalten wird; und
ein Abschirmmodul, das dafür eingerichtet ist, die zweite Quarzkristalloszillatorbahn während der Filmbeschichtung abzuschirmen, um zu verhindern, dass die zweite Quarzkristalloszillatorbahn mit dem Film beschichtet wird;
**dadurch gekennzeichnet, dass** die Messvorrichtung des Weiteren eine Vakuumadsorptionsvorrichtung umfasst, die eine Adsorptionsoberfläche umfasst und dafür eingerichtet ist, das zu beschichtende Modul zu adsorbieren, wobei die erste Quarzkristalloszillatorbahn und die zweite Quarzkristalloszillatorbahn auf einem Niveau angeordnet sind, das mit dem zu beschichtenden Modul identisch ist;
das erste Quarzkristalloszillatorbahn und die zweite Quarzkristalloszillatorbahn kreisförmig angeordnet sind, das Abschirmmodul eine drehbare Abschirmbahn mit einem Durchgangsloch ist und die drehbare Abschirmbahn so gedreht wird, dass das Durchgangsloch über verschiedenen Quarzkristalloszillatorbahnen liegen kann;
mehrere zweite Quarzkristalloszillatorbahnen vorhanden sind, und das zweite Berechnungsmodul dafür eingerichtet ist, einen Frequenzvariations-Medianwert jeder zweiten Quarzkristalloszillatorbahn gemäß dem zweiten Antwortsignal zu berechnen, das in Reaktion auf den Wechselstrom durch jede zweite Quarzkristalloszillatorbahn während der Filmbeschichtung generiert wird, und einen Mittelwert aller Frequenzvariations-Medianwerte als den Frequenzvariations-Modifizierungswert zu berechnen.

2. Messvorrichtung nach Anspruch 1, wobei der Frequenzvariations-Zielwert gleich einer Differenz zwischen dem Frequenzvariations-Anfangswert und dem Frequenzvariations-Modifizierungswert ist.

3. Filmbeschichtungsvorrichtung, umfassend eine Filmbeschichtungsmaschine, die dafür eingerichtet ist, ein zu beschichtendes Modul mit einem Film beschichten, und eine Messvorrichtung umfasst, wobei die Messvorrichtung Folgendes umfasst:

eine erste Quarzkristalloszillatorbahn, die während der Filmbeschichtung mit dem Film beschichtet wird;
eine zweite Quarzkristalloszillatorbahn, die mit der ersten Quarzkristalloszillatorbahn identisch ist und während der Filmbeschichtung so abgeschirmt wird, dass sie nicht mit dem Film beschichtet wird;

eine Erregungsquellengenerierungseinheit, die dafür eingerichtet ist, Wechselstrom zu generieren und den Wechselstrom an die erste Quarzkristalloszillatorbahn und die zweite Quarzkristalloszillatorbahn auszugeben;

ein erstes Berechnungsmodul, das dafür eingerichtet ist, einen Frequenzvariations-Anfangswert gemäß einem ersten Antwortsignal zu berechnen, das in Reaktion auf den Wechselstrom durch die erste Quarzkristalloszillatorbahn während der Filmbeschichtung generiert wird;

ein zweites Berechnungsmodul, das dafür eingerichtet ist, einen Frequenzvariations-Modifizierungswert gemäß einem zweites Antwortsignal zu berechnen, das in Reaktion auf den Wechselstrom durch die zweite Quarzkristalloszillatorbahn während der Filmbeschichtung generiert wird;

ein drittes Berechnungsmodul, das dafür eingerichtet ist, eine Dicke des Films gemäß einem Frequenzvariations-Zielwert zu berechnen, der durch Modifizieren des Frequenzvariations-Anfangswertes mit dem Frequenzvariations-Modifizierungswert erhalten wird; und

ein Abschirmmodul, das dafür eingerichtet ist, die zweite Quarzkristalloszillatorbahn während der Filmbeschichtung abzuschirmen, um zu verhindern, dass die zweite Quarzkristalloszillatorbahn mit dem Film beschichtet wird;

**dadurch gekennzeichnet, dass** die Messvorrichtung des Weiteren eine Vakuumadsorptionsvorrichtung umfasst, die eine Adsorptionsoberfläche umfasst und dafür eingerichtet ist, das zu beschichtende Modul zu adsorbieren, wobei die erste Quarzkristalloszillatorbahn und die zweite Quarzkristalloszillatorbahn auf einem Niveau angeordnet sind, das mit dem zu beschichtenden Modul identisch ist;

das erste Quarzkristalloszillatorbahn und die zweite Quarzkristalloszillatorbahn kreisförmig angeordnet sind, das Abschirmmodul eine drehbare Abschirmbahn mit einem Durchgangsloch ist und die drehbare Abschirmbahn so gedreht wird, dass das Durchgangsloch über verschiedenen Quarzkristalloszillatorbahnen liegen kann;

mehrere zweite Quarzkristalloszillatorbahnen vorhanden sind, und das zweite Berechnungsmodul dafür eingerichtet ist, einen Frequenzvariations-Medianwert jeder zweiten Quarzkristalloszillatorbahn gemäß dem zweiten Antwortsignal zu berechnen, das in Reaktion auf den Wechselstrom durch jede zweite Quarzkristalloszillatorbahn während der Filmbeschichtung generiert wird, und einen Mittelwert aller Frequenzvariations-Medianwerte als den Frequenzvariations-Modifizierungswert zu berechnen.

4. Filmbeschichtungsvorrichtung nach Anspruch 3, wobei der Frequenzvariations-Zielwert gleich einer Differenz zwischen dem Frequenzvariations-Anfangswert und dem Frequenzvariations-Modifizierungswert ist.

5. Filmbeschichtungsvorrichtung nach Anspruch 3, des Weiteren umfassend:
eine Steuereinheit, die dafür eingerichtet ist, eine Dicke des durch die Filmbeschichtungsmaschine aufbeschichteten Films gemäß einem Ist-Wert der Filmdicke zu steuern.

## Revendications

1. Appareil de mesure permettant de mesurer l'épaisseur d'un film formé sur un module à revêtir, comprenant :

une première feuille d'oscillateur à quartz revêtue du film pendant l'application de film ;
une seconde feuille d'oscillateur à quartz identique à la première feuille d'oscillateur à quartz et protégée pendant l'application de film, de manière à ne pas être revêtue du film ;
une unité de génération de source d'excitation conçue pour engendrer un courant alternatif et délivrer le courant alternatif à la première feuille d'oscillateur à quartz et à la seconde feuille d'oscillateur à quartz ;
un premier module de calcul, conçu pour calculer une valeur initiale de variation de fréquence en fonction d'un premier signal de réponse produit en réponse au courant alternatif par la première feuille d'oscillateur à quartz pendant l'application de film ;
un deuxième module de calcul, conçu pour calculer une valeur modifiée de variation de fréquence en fonction d'un second signal de réponse produit en réponse au courant alternatif par la seconde feuille d'oscillateur à quartz pendant l'application de film ;
un troisième module de calcul, conçu pour calculer une épaisseur du film en fonction d'une valeur cible de variation de fréquence, obtenue par modification de la valeur initiale de variation de fréquence par la valeur modifiée de variation de fréquence ; et
un module de protection conçu pour protéger la seconde feuille d'oscillateur à quartz pendant l'application de film, de manière à empêcher que la seconde feuille d'oscillateur à quartz soit revêtue du film ;
**caractérisé en ce que** l'appareil de mesure comprend en outre un appareil d'adsorption sous vide comprenant une surface d'adsorption et étant conçu pour adsorber le module à revêtir, dans lequel la première feuille d'oscillateur à quartz et la seconde feuille d'oscillateur à quartz sont disposées à un niveau identique à celui du module à revêtir ;

la première feuille d'oscillateur à quartz et la seconde feuille d'oscillateur à quartz sont disposées de manière circulaire, le module de protection est une feuille de protection rotative dotée d'un trou de liaison, et la feuille de protection rotative est tournée de manière à permettre au trou de liaison de se trouver au-dessus de différentes feuilles d'oscillateur à quartz ;

il existe une pluralité de secondes feuilles d'oscillateur à quartz, et le deuxième module de calcul est conçu pour calculer une valeur médiane de variation de fréquence de chaque seconde feuille d'oscillateur à quartz en fonction du second signal de réponse produit en réponse au courant alternatif par chaque seconde feuille d'oscillateur à quartz pendant l'application de film, et pour calculer une valeur médiane de toutes les valeurs médianes de variation de fréquence en tant que valeur modifiée de variation de fréquence.

**2.** Appareil de mesure selon la revendication 1, dans lequel la valeur cible de variation de fréquence est égale à une différence entre la valeur initiale de variation de fréquence et la valeur modifiée de variation de fréquence.

**3.** Dispositif d'application de film, comprenant une machine d'application de film conçue pour revêtir un module à revêtir avec un film, et un appareil de mesure, dans lequel l'appareil de mesure comprend :

une première feuille d'oscillateur à quartz revêtue du film pendant l'application de film ;

une seconde feuille d'oscillateur à quartz identique à la première feuille d'oscillateur à quartz et protégée pendant l'application de film, de manière à ne pas être revêtue du film ;

une unité de génération de source d'excitation conçue pour engendrer un courant alternatif et délivrer le courant alternatif à la première feuille d'oscillateur à quartz et à la seconde feuille d'oscillateur à quartz ;

un premier module de calcul, conçu pour calculer une valeur initiale de variation de fréquence en fonction d'un premier signal de réponse produit en réponse au courant alternatif par la première feuille d'oscillateur à quartz pendant l'application de film ;

un deuxième module de calcul, conçu pour calculer une valeur modifiée de variation de fréquence en fonction d'un second signal de réponse produit en réponse au courant alternatif par la seconde feuille d'oscillateur à quartz pendant l'application de film ;

un troisième module de calcul, conçu pour calculer une épaisseur du film en fonction d'une valeur cible de variation de fréquence obtenue par modification de la valeur initiale de variation de fréquence par la valeur modifiée de variation de fréquence ; et

un module de protection conçu pour protéger la seconde feuille d'oscillateur à quartz pendant l'application de film, de manière à empêcher que la seconde feuille d'oscillateur à quartz soit revêtue du film ;

**caractérisé en ce que** l'appareil de mesure comprend en outre un appareil d'adsorption sous vide comprenant une surface d'adsorption et étant conçu pour adsorber le module à revêtir, dans lequel la première feuille d'oscillateur à quartz et la seconde feuille d'oscillateur à quartz sont disposées à un niveau identique à celui du module à revêtir ;

la première feuille d'oscillateur à quartz et la seconde feuille d'oscillateur à quartz sont disposées de manière circulaire, le module de protection est une feuille de protection rotative dotée d'un trou de liaison, et la feuille de protection rotative est tournée de manière à permettre au trou de liaison de se trouver au-dessus de différentes feuilles d'oscillateur à quartz ;

il existe une pluralité de secondes feuilles d'oscillateur à quartz, et le deuxième module de calcul est conçu pour calculer une valeur médiane de variation de fréquence de chaque seconde feuille d'oscillateur à quartz en fonction du second signal de réponse produit en réponse au courant alternatif par chaque seconde feuille d'oscillateur à quartz pendant l'application de film, et pour calculer une valeur médiane de toutes les valeurs médianes de variation de fréquence en tant que valeur modifiée de variation de fréquence.

**4.** Dispositif d'application de film selon la revendication 3, dans lequel la valeur cible de variation de fréquence est égale à une différence entre la valeur initiale de variation de fréquence et la valeur modifiée de variation de fréquence.

**5.** Dispositif d'application de film selon la revendication 3, comprenant en outre :
un dispositif de régulation conçu pour réguler une épaisseur du film appliqué par la machine d'application de film, en fonction d'une valeur réelle de l'épaisseur du film.

101

104

103

102

102

102

Fig. 1

201 vacuum adsorption apparatus 205 202

quartz-crystal
oscillator sheet

to-be-coated module

quartz-crystal
oscillator sheet

shielding plate

203

204

200

crucible

Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020152803 A1